(19) Europäisches Patentamt / European Patent Office / Office européen des brevets

(11) **EP 2 638 249 B1**

(12) **FASCICULE DE BREVET EUROPEEN**

(45) Date de publication et mention
de la délivrance du brevet:
**05.04.2017 Bulletin 2017/14**

(21) Numéro de dépôt: **11799756.9**

(22) Date de dépôt: **08.11.2011**

(51) Int Cl.:
***F01D 5/14*** *(2006.01)*

(86) Numéro de dépôt international:
**PCT/FR2011/052591**

(87) Numéro de publication internationale:
**WO 2012/062991 (18.05.2012 Gazette 2012/20)**

(54) **PROCEDE D'OPTIMISATION DU PROFIL D'UNE AUBE POUR ROUE MOBILE DE TURBOMACHINE**

OPTIMIERUNGSVERFAHREN DES PROFILS EINER ROTORSCHAUFEL VON EINER TURBOMASCHINE

PROFILE OPTIMISATION OF A TURBOMACHINE ROTOR BLADE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.11.2010 FR 1059292**

(43) Date de publication de la demande:
**18.09.2013 Bulletin 2013/38**

(73) Titulaires:
• **Snecma**
**75015 Paris (FR)**
• **HERAKLES**
**33185 Le Haillan (FR)**

(72) Inventeurs:
• **DUVAL, Sylvain, Yves, Jean**
**F-77220 Tournan En Brie (FR)**

• **ROUSSILLE, Clément**
**F-33200 Bordeaux (FR)**
• **SCHWEITZER, Alain**
**F-33187 Le Haillan Cedex (FR)**
• **GIRARD, Patrick, Joseph, Marie**
**F-77310 Saint Fargeau Ponthierry (FR)**

(74) Mandataire: **Boura, Olivier**
**Cabinet Beau de Loménie**
**158, rue de l'Université**
**75340 Paris Cedex 07 (FR)**

(56) Documents cités:
**EP-A1- 1 939 458     US-A- 4 012 172
US-A- 4 585 395**

**Description**

Arrière-plan de l'invention

La présente invention se rapporte au domaine général de la conception d'une aube en matériau composite pour roue mobile de turbomachine.

Le domaine visé est celui des aubes mobiles de turbines à gaz pour moteurs aéronautiques ou turbines industrielles.

La réalisation d'aubes en matériau composite, notamment en CMC (composite à matrice céramique) pour des turbomachines a déjà été proposée. On se référera notamment au document FR 2,939,129 qui décrit la fabrication d'une aube de turbomachine en matériau composite comprenant un renfort fibreux densifié par une matrice.

En outre, le document US4012172 décrit un procédé d'optimisation du profil d'une aube pour roue mobile de turbomachine.

Il est connu que les aubes métalliques présentent des caractéristiques de tenue mécanique qui se détériorent fortement aux hautes températures, ce qui nécessite d'optimiser le profil géométrique de ces aubes dans les zones chaudes, à savoir leur pale, afin de réduire les contraintes mécaniques à laquelle les aubes sont soumises en fonctionnement.

Au contraire des aubes métalliques, les aubes en CMC présentent des caractéristiques de tenue mécanique qui résistent mieux aux hautes températures, ce qui reporte la zone critique de l'aube au niveau de son pied (qui est la partie froide). Il en résulte l'apparition de contraintes mécaniques élevées au niveau du pied de l'aube lors de la rotation de celle-ci.

Objet et résumé de l'invention

La présente invention a donc pour but principal de pallier de tels inconvénients en proposant un procédé d'optimisation du profil d'une aube en matériau composite permettant de réduire les contraintes mécaniques à laquelle l'aube est soumise en fonctionnement.

Ce but est atteint grâce à un procédé d'optimisation du profil d'une aube en matériau composite selon la revendication 1, l'aube comprenant une pale constituée d'une pluralité de sections d'aubes empilées selon une direction radiale à la roue, un pied destiné à être monté sur un disque de la roue et prolongé par une échasse, et une plateforme située entre l'échasse et la pale, le pied se raccordant à l'échasse par un col, le procédé comprenant, conformément à l'invention, les étapes suivantes :

une étape de compensation de la pale de l'aube consistant à diviser la pale en des tranches délimitées chacune entre une section inférieure et une section supérieure, et pour chaque tranche de pale et un régime de rotation prédéterminé du disque de la roue, calculer la force centrifuge à laquelle est soumise la tranche, calculer le moment de la force aérodynamique s'exerçant sur la section inférieure de la tranche, et calculer des valeurs de déplacements à appliquer à un centre de gravité de la tranche selon des directions tangentielle et longitudinale pour annuler le moment de la force aérodynamique s'exerçant sur la section inférieure de ladite tranche ; et

une étape de compensation de l'échasse de l'aube consistant à calculer la force centrifuge à laquelle est soumise une portion de l'aube située au-dessus du col et constituée de la pale, de la plateforme et de l'échasse, calculer le moment de la force aérodynamique s'exerçant sur une section inférieure de l'échasse de l'aube, et calculer des valeurs de déplacements à appliquer à un centre de gravité de l'échasse de l'aube selon les directions tangentielle et longitudinale pour annuler le moment de la force aérodynamique s'exerçant sur la section inférieure de l'échasse de l'aube.

En fonctionnement, l'aube est soumise à la fois à des efforts aérodynamiques induits par l'écoulement de gaz traversant la turbomachine et à des efforts centrifuges dus à la rotation de la roue. L'étape de compensation de la pale selon le procédé de l'invention consiste à déplacer (selon des directions tangentielle et longitudinale) les centres de gravité des différentes sections d'aube de la pale afin de compenser le moment de flexion induit par les efforts aérodynamiques par le moment de flexion induit par les efforts centrifuges. Plus précisément, les efforts aérodynamiques génèrent un moment en bas de pale. En décalant les centres de gravité des différentes tranches de la pale dans le même sens que les efforts aérodynamiques, on créé un moment généré par l'effort centrifuge qui est opposé au moment induit par les efforts aérodynamiques.

Par ailleurs, les efforts aérodynamiques génèrent également un moment au niveau de l'échasse de celle-ci. Le procédé selon l'invention prévoit au cours de l'étape de compensation de l'échasse de compenser ce moment par le moment de flexion induit par les efforts centrifuges et donc d'obtenir un équilibre des moments au niveau de l'échasse de l'aube.

En créant un équilibre des moments à la fois au niveau du bas de pale et au niveau de l'échasse de l'aube, il est ainsi possible de réduire les contraintes mécaniques à laquelle l'aube est soumise en fonctionnement. Il en résulte une augmentation de la durée de vie de l'aube et la possibilité d'utiliser un matériau avec une tenue mécanique plus faible (ou plus limitée) dans la zone du pied de l'aube que les matériaux métalliques traditionnels. Par ailleurs, l'optimisation du profil de l'échasse de l'aube se fait au bénéfice de sa masse et de son encombrement.

Avantageusement, les valeurs de déplacements à appliquer aux centres de gravité des tranches de pale et à l'échasse de l'aube sont lissées sur toute la hauteur de l'aube. Cette opération permet d'obtenir un profil de la pale qui ne nuit pas aux performances aérodynamiques de l'aube.

La force centrifuge à laquelle est soumise une tranche de pale peut être donnée par la formule suivante :

$$F_C = M_T \times R_{CDG} \times \omega^2$$

avec : $M_T$ pour la masse de la tranche de pale, $R_{CDG}$ pour la distance entre l'axe de rotation du disque et le centre de gravité de la tranche de pale ; et $\omega$ pour la vitesse de rotation disque au régime prédéterminé.

Selon la revendication 1, les valeurs de déplacements à appliquer au centre de gravité d'une tranche de pale sont données par les formules suivantes :

$$\delta_X = M_{Y\text{-faéro}} / F_C$$

$$\delta_Y = M_{X\text{-faéro}} / F_C$$

avec : $M_{X\text{-faéro}}$ pour la composante du moment de la force aérodynamique s'exerçant sur la section inférieure de la tranche selon la direction longitudinale ; et $M_{Y\text{-faéro}}$ pour la composante du moment de la force aérodynamique s'exerçant sur la section inférieure de la tranche selon la direction tangentielle.

De même, les valeurs de déplacements ($\delta'_X$, $\delta'_Y$) à appliquer au centre de gravité d'une tranche de pale sont données par les formules suivantes :

$$\delta'_X = M'_{Y\text{-faéro}} / F'_C$$

$$\delta'_Y = M'_{X\text{-faéro}} / F'_C$$

avec : $M'_{X\text{-faéro}}$ pour la composante du moment de la force aérodynamique s'exerçant sur la section inférieure de l'échasse de l'aube selon la direction longitudinale ; et $M'_{Y\text{-faéro}}$ pour la composante du moment de la force aérodynamique s'exerçant sur la section inférieure de l'échasse de l'aube selon la direction tangentielle.

Lorsque l'aube comprend en outre un talon au voisinage de l'extrémité libre de la pale, l'étape de compensation de l'échasse s'applique de préférence à une portion de l'aube constituée de la pale, de la plateforme, de l'échasse et du talon de l'aube.

Dans l'étape de compensation de la pale de l'aube, la pale peut être divisée en dix tranches s'étendant chacune sur 10% de la hauteur totale de la pale.

Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :

- la figure 1 est une vue schématique et en perspective d'un exemple d'aube à laquelle s'applique le procédé selon l'invention ; et
- la figure 2 indique les étapes successives d'un procédé d'optimisation du profil d'une aube selon l'invention.

Description détaillée d'un mode de réalisation

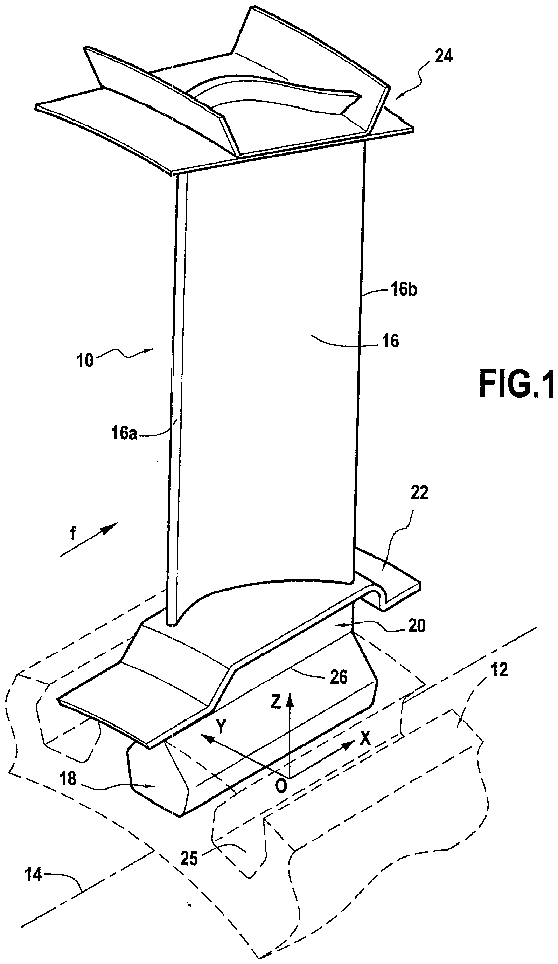

L'invention est applicable à différents types d'aubes de turbomachine, notamment des aubes de compresseur et de turbine de différents corps de turbines à gaz, par exemple une aube de roue mobile de turbine basse pression, telle que celle illustrée sur la figure 1.

L'aube 10 de la figure 1 est destinée à être montée sur un disque 12 d'une roue mobile centrée sur un axe longitudinal 14 de la turbomachine. Cette roue mobile définit trois axes perpendiculaires formant un repère orthogonal (O,X,Y,Z) défini par un axe longitudinal X (parallèle à l'axe longitudinal 14 de la turbomachine), un axe tangentiel Y et un axe radial Z, l'origine O du repère étant centré sur l'axe longitudinal 14 de la turbomachine.

De façon en soi bien connue, l'aube 10 comprend une pale 16, un pied 18 formé par une partie de plus forte épaisseur, par exemple à section en forme de bulbe, prolongé par une échasse 20, une plateforme intérieure 22 située entre l'échasse et la pale et une plateforme extérieure ou talon 24 au voisinage de l'extrémité libre de la pale. L'aube est constituée d'une pluralité de sections d'aubes qui sont empilées selon l'axe radial Z.

La pale 16 s'étend selon l'axe radial Z entre la plateforme 22 et le talon 24 et présente en section transversale un profil incurvé d'épaisseur variable entre son bord d'attaque 16a et son bord de fuite 16b.

L'aube 10 est montée sur le disque 12 par engagement du pied 18 dans un logement 25 de forme correspondante aménagé à la périphérie du disque. Le pied 18 se raccorde à l'échasse 20 par un col 26.

A son extrémité radiale interne, la pale 16 se raccorde à la plateforme 22 qui délimite, à l'intérieur, la veine d'écoulement de flux gazeux dans la turbine. A son extrémité radiale externe, la pale 16 se raccorde au talon 24 qui délimite, à l'extérieur, la veine d'écoulement du flux gazeux dans la turbine.

L'aube 10 est réalisée en matériau composite, par exemple en CMC. On pourra se référer au document FR 2,939,129 qui décrit un exemple de fabrication d'une telle aube.

En fonctionnement, cette aube est soumise, d'une part à des efforts aérodynamiques induits par l'écoulement de flux gazeux traversant la turbine, et d'autre part à des efforts centrifuges dus à la rotation de la roue mobile 12 autour de l'axe longitudinal 14. Ces efforts (aérodynamiques et centrifuges) génèrent notamment des moments de flexion au niveau du bas de la pale (c'est-à-dire au voisinage de la plateforme 22), mais également au niveau du col 26 raccordant le pied 18 à l'échasse 20.

Selon l'invention, il est prévu d'optimiser le profil de l'aube pour obtenir un équilibre entre les moments de flexion induits par les efforts aérodynamiques et les moments de flexion induits par les efforts centrifuges. Cette optimisation est pratiquée pour une phase de vol particulière qui est notamment caractérisée par un régime de rotation prédéterminé ω du disque de la roue.

De manière générale, l'optimisation du profil de l'aube consiste à déplacer selon des directions tangentielle et longitudinale les centres de gravité des différentes sections d'aube pour parvenir à un tel équilibre. Idéalement, si l'optimisation est optimale, les sections d'aube ne seront plus sollicitées en flexion mais seulement en traction pure (efforts centrifuges).

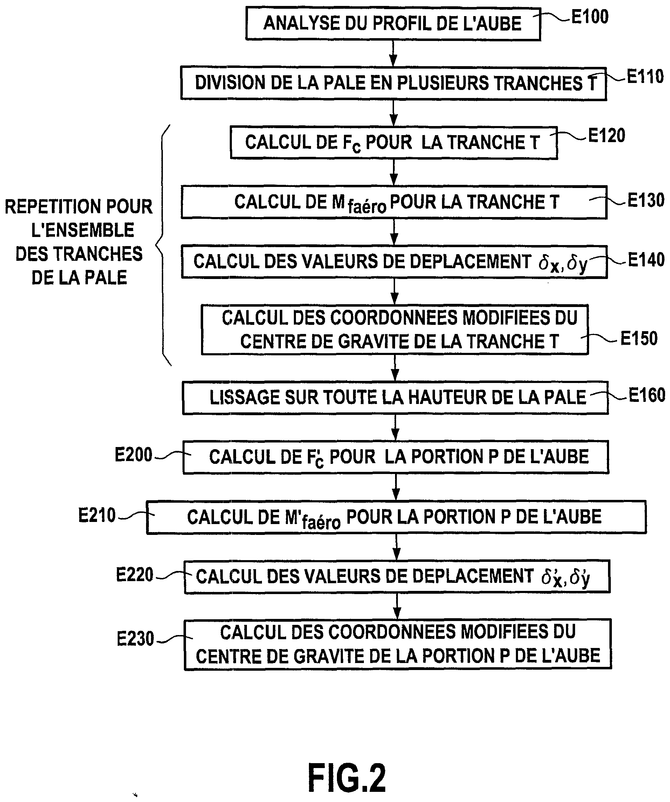

La figure 2 représente les différentes étapes d'un procédé selon l'invention pour optimiser le profil de l'aube. Ces étapes sont mises en oeuvre au moyen d'un logiciel de calcul adéquat. Elles comprennent des étapes de compensation de la pale de l'aube et des étapes de compensation de l'échasse de l'aube. Un exemple d'application de ce procédé sera décrit ultérieurement.

Selon une première étape E100 du procédé, les valeurs relatives au profil géométrique de l'aube, ses dimensions et sa masse sont entrées dans le logiciel de calcul.

Pour réaliser la compensation de la pale de l'aube, celle-ci est d'abord divisée géométriquement selon l'axe radial Z en plusieurs tranches T, chaque tranche de pale T étant délimitée entre une section d'aube inférieure et une section d'aube supérieure (étape E110). Par exemple, on choisira dix tranches T s'étendant chacune sur 10% de la distance radiale totale séparant le talon de la plateforme de l'aube.

A chaque tranche de pale ainsi définie, sont associés une masse $M_T$ de la tranche et des coordonnées $(C_X, C_Y, C_Z)$ du centre de gravité de cette tranche dans le repère orthogonal (O,X,Y,Z) préalablement défini.

Pour chaque tranche de pale T et pour le régime de rotation prédéterminé ω du disque de la roue, la force centrifuge $F_C$ à laquelle est soumise la tranche est alors calculée (étape E120). Ce calcul est donné par l'équation suivante :

$$F_C = M_T \times R_{CDG} \times \omega^2$$

où $R_{CDG}$ représente la distance entre l'axe de rotation du disque et le centre de gravité de la tranche de pale (c'est-à-dire que $R_{CDG}$ correspond à la valeur de $C_Z$).

Parallèlement à cette étape E120, le moment $M_{faéro}$ des efforts aérodynamiques s'exerçant sur la section inférieure de cette même tranche de pale T, et plus précisément les composantes $M_{X\text{-faéro}}$ selon la direction longitudinale et $M_{Y\text{-faéro}}$ selon la direction tangentielle de ce moment, est calculé (étape E130). Ce calcul est réalisé à partir des efforts aérodynamiques calculés avec un logiciel adéquat et de la distance entre le centre de poussée aérodynamique de la tranche étudiée et la section inférieure de cette tranche.

A partir de ces données $F_C$, $M_{X\text{-faéro}}$ et $M_{Y\text{-faéro}}$, des valeurs de déplacements à appliquer aux coordonnées $(C_X, C_Y, C_Z)$ du centre de gravité de la tranche de pale T en question peuvent être calculées au cours d'une étape E140.

Plus précisément, ces valeurs de déplacement sont calculées de sorte à compenser (c'est-à-dire annuler) le moment $M_{\text{faéro}}$ des efforts aérodynamiques s'exerçant sur la section inférieure de la tranche de pale T et sont obtenues par les équations suivantes :

$$\delta_X = M_{Y\text{-faéro}} \,/\, F_C$$

$$\delta_Y = M_{X\text{-faéro}} \,/\, F_C$$

où $\delta_X$ et $\delta_Y$ sont les valeurs de déplacement à appliquer aux coordonnées $C_X$ et $C_Y$, respectivement, du centre de gravité de la tranche de pale T.

A l'étape suivante E150, on calcule alors les coordonnées modifiées $(C'_X, C'_Y, C'_Z)$ dans le repère $(O, X, Y, Z)$ pour le centre de gravité de la tranche de pale T à l'aide des formules suivantes :

$$C'_X = C_X + \delta_X$$

$$C'_Y = C_Y + \delta_Y$$

$$C'_Z = C_Z$$

Les étapes E120 à E150 énumérées ci-dessus sont répétées pour l'ensemble des tranches de pale T, en partant de la tranche supérieure (c'est-à-dire celle située au voisinage du talon de l'aube) et en descendant jusqu'à la tranche inférieure (c'est-à-dire celle située au voisinage de la plateforme). A l'issue de ces étapes, on obtient des coordonnées modifiées pour les centres de gravité de l'ensemble des tranches de pale. Le profil de la pale est ainsi optimisé pour une phase de vol prédéfinie.

De façon avantageuse, une étape supplémentaire E160 consiste à lisser l'ensemble des coordonnées modifiées $(C'_X, C'_Y, C'_Z)$ ainsi obtenus sur toute la hauteur de la pale. Cette opération peut être réalisée par toute méthode de lissage de valeurs connue en soi. Elle permet d'obtenir un alignement des centres de gravité des différentes tranches de pale sur une courbe qui ne pénalisera pas les performances aérodynamiques de la pale.

Suite à ces étapes, la compensation de l'échasse de l'aube est réalisée de manière analogue. Une première étape E200 consiste à calculer la force centrifuge $F_C$ à laquelle est soumise la portion P de l'aube constituée de la pale, de la plateforme et de l'échasse (c'est-à-dire tout ce qui est au-dessus du col de l'aube). Cette force centrifuge $F'_C$ est donnée par la formule suivante :

$$F'_C = M_P \times R'_{CDG} \times \omega^2$$

avec : $M_P$ pour la masse de la portion P de l'aube, $R'_{CDG}$ pour la distance entre l'axe de rotation du disque et le centre de gravité de cette portion P de l'aube ; et $\omega$ pour la vitesse de rotation disque au régime prédéterminé.

On notera que si l'aube comprend un talon muni de léchettes (comme celle illustrée par la figure 1), la portion P de l'aube sera constituée de tout ce qui se situe au-dessus du col de l'aube, à savoir la pale, l'échasse, la plateforme, le talon et ses léchettes.

Le moment $M'_{\text{faéro}}$ de la force aérodynamique s'exerçant sur la section inférieure de l'échasse de l'aube, et plus précisément les composantes $M'_{X\text{-faéro}}$ selon la direction longitudinale et $M'_{Y\text{-faéro}}$ selon la direction tangentielle de ce moment, est calculé (étape E210). Ce calcul est réalisé à l'aide du logiciel de calcul de manière analogue à la modélisation décrite à l'étape E130.

A partir de ces données $F'_C$, $M'_{X\text{-faéro}}$ et $M'_{Y\text{-faéro}}$, des valeurs de déplacements $\delta'_X$, $\delta'_Y$ à appliquer aux coordonnées D'$_X$ et D'$_Y$, respectivement, du centre de gravité de l'échasse de l'aube peuvent être calculés au cours d'une étape E220. Ces valeurs de déplacement valeurs (dites également valeurs de compensation de l'échasse) sont calculées de sorte à compenser le moment M'$_{faéro}$ des efforts aérodynamiques et sont obtenues par les équations suivantes :

$$\delta'_X = M'_{Y\text{-faéro}} / F'_C$$

$$\delta'_Y = M'_{X\text{-faéro}} / F'_C$$

Les coordonnées modifiées (D'$_X$,D'$_Y$,D'$_Z$) dans le repère (O,X,Y,Z) pour le centre de gravité de l'échasse de l'aube sont alors les suivantes :

$$D'_X = D_X + \delta'_X$$

$$D'_Y = D_Y + \delta'_Y$$

$$D'_Z = D_Z$$

où D$_X$, D$_Y$ et D$_Z$ sont les coordonnées du centre de gravité de l'échasse de l'aube dans le repère (O,X,Y,Z) sans compensation.

A partir de ces valeurs de déplacement et des coordonnées des centres de gravité de l'échasse de l'aube et des différentes tranches T de pale précédemment calculés, on calcule alors au cours de l'étape E230 les coordonnées modifiées pour le centre de gravité de la portion P de l'aube située au-dessus du col de façon identique à l'étape E150.

Exemple d'application

Dans cet exemple, l'aube est une aube de turbine basse pression de turbomachine réalisée en CMC.

Pour réaliser la compensation de la pale d'une telle aube, celle-ci est divisée géométriquement en dix tranches de pale s'étendant chacune sur 10% de la hauteur radiale totale séparant le talon de la plateforme de l'aube.

Le tableau ci-dessous donne les valeurs de déplacement à appliquer aux coordonnées du centre de gravité de la tranche de pale située entre 90% et 100% de la hauteur radiale totale de la pale lors de la compensation de pale (étapes E100 à E160). Cette tranche est la tranche supérieure qui est située directement au voisinage du talon de l'aube.

Compensation de la tranche de pale située entre 90% et 100%

| | | |
|---|---|---|
| M$_{faéro}$ (en N.mm) | M$_{X\text{-faéro}}$ | 106,8 |
| | M$_{Y\text{-faéro}}$ | 132,1 |
| Masse de la tranche de pale (en g) | | 2,72 |
| Masse du talon de l'aube | | 15 |
| Régime de rotation prédéterminé $\omega$ (en tours/mn) | | 4000 |
| F$_C$(en N) | | 1739 |
| Valeurs de déplacement à appliquer au CDG de la tranche de pale (en mm) | $\delta_X$ | 0,076 |
| | $\delta_Y$ | 0,061 |
| Moment généré dans la section inférieure de la tranche par le déplacement du CDG de la tranche (en N.mm) | selon direction X | -106,8 |
| | selon direction Y | -132,1 |

Ainsi, pour la tranche de pale située entre 90% et 100% de la hauteur radiale totale de la pale, la position du centre de gravité de cette tranche de pale devra être déplacée (par rapport à ses coordonnées d'origine) de +0,061mm selon la direction X et de +0,076mm selon la direction Y.

On notera que pour cette tranche supérieure située entre 90% et 100% de la hauteur totale de la pale, la masse du talon située au-dessus d'elle est pris en compte pour le calcul de la force centrifuge s'appliquant sur celle-ci (en plus de la masse de la tranche). De même, le calcul de la position du centre de gravité de cette tranche prend en compte la présence de ce talon.

Les valeurs de déplacement à appliquer aux autres tranches de pale seront calculées de la même façon et ne seront donc pas détaillées ici. En particulier, on calculera ces valeurs de déplacement pour la tranche de pale située entre 80% et 90% de la hauteur radiale totale de la pale, puis pour la tranche située entre 70% et 80%, puis pour la tranche située entre 60% et 70%, etc. jusqu'à la dernière tranche située entre 0% et 10%.

Pour cette même aube, le tableau ci-après donne les valeurs de déplacement à appliquer aux coordonnées du centre de gravité de la portion P de l'aube constituée de la pale, de la plateforme, de l'échasse et du talon (c'est-à-dire tout ce qui est au-dessus du col) lors de la compensation de l'échasse (étapes E200 à E230).

Compensation de la portion P de l'aube au-dessus du col

| M'$_{faéro}$ (en N.mm) | M'$_{X-faéro}$ | 12931 |
|---|---|---|
| | M'$_{Y-faéro}$ | 18560 |
| Masse de la portion P de l'aube (en g) | | 92,97 |
| Régime de rotation prédéterminé ω (en tours/mn) | | 4000 |
| F'$_C$ (en N) | | 7483 |
| Valeurs de déplacement à appliquer au CDG de la portion P de l'aube (en mm) | δ'$_X$ | 2,48 |
| | δ'$_Y$ | 1,73 |
| Moment généré dans le col par le déplacement du CDG de la portion P de l'aube (en N.mm) | selon direction X | -12931 |
| | selon direction Y | -18560 |

Ainsi, pour la portion P de l'aube constituée de la pale, de la plateforme, de l'échasse et du talon, la position du centre de gravité de cette portion de l'aube devra être déplacée (par rapport à ses coordonnées d'origine) de +1,73mm selon la direction X et de +2,48mm selon la direction Y.

On notera que ces compensations de pale et de la portion d'aube située au-dessus du col sont calculées pour un régime de rotation prédéterminé de la roue, c'est-à-dire pour une phase de vol particulière. Il est possible d'effectuer de tels calculs pour plusieurs régimes de rotation prédéterminés (et donc plusieurs phases de vol) et d'effectuer une moyenne pour l'ensemble des données obtenues.

**Revendications**

1. Procédé d'optimisation du profil d'une aube en matériau composite pour roue mobile de turbomachine, l'aube comprenant une pale constituée d'une pluralité de sections d'aubes empilées selon une direction radiale à la roue, un pied destiné à être monté sur un disque de la roue et prolongé par une échasse, et une plateforme située entre l'échasse et la pale, le pied se raccordant à l'échasse par un col, le procédé étant **caractérisé en ce qu'**il comprend les étapes successives suivantes :

   une étape de compensation de la pale de l'aube consistant à diviser la pale en des tranches délimitées chacune entre une section inférieure et une section supérieure (E110), et pour chaque tranche de pale et un régime de rotation prédéterminé du disque de la roue, calculer la force centrifuge (F$_C$) à laquelle est soumise la tranche (E120), calculer le moment de la force aérodynamique s'exerçant sur la section inférieure de la tranche (E130), et calculer des valeurs de déplacements (E140) à appliquer à un centre de gravité de la tranche selon des directions tangentielle et longitudinale pour annuler le moment de la force aérodynamique s'exerçant sur la section inférieure de ladite tranche, les valeurs de déplacements ($\delta_X$, $\delta_Y$) à appliquer au centre de gravité d'une tranche de pale étant données par les formules suivantes :

$$\delta_X = M_{\text{Y-faéro}} / F_C$$

$$\delta_Y = M_{\text{X-faéro}} / F_C$$

avec : $M_{\text{X-faéro}}$ pour la composante du moment de la force aérodynamique s'exerçant sur la section inférieure de la tranche selon la direction longitudinale ; et $M_{\text{Y-faéro}}$ pour la composante du moment de la force aérodynamique s'exerçant sur la section inférieure de la tranche selon la direction tangentielle ; et

une étape de compensation de l'échasse de l'aube consistant à calculer la force centrifuge ($F'_C$) à laquelle est soumise une portion de l'aube située au-dessus du col et constituée de la pale (E200), de la plateforme et de l'échasse, calculer le moment de la force aérodynamique s'exerçant sur la section inférieure de l'échasse de l'aube (E210), et calculer des valeurs de déplacements (E220) à appliquer à un centre de gravité de l'échasse de l'aube selon les directions tangentielle et longitudinale pour annuler le moment de la force aérodynamique s'exerçant sur la section inférieure de l'échasse de l'aube, les valeurs de déplacements ($\delta'_X$, $\delta'_Y$) à appliquer au centre de gravité d'une tranche de l'échasse étant données par les formules suivantes :

$$\delta'_X = M'_{\text{Y-faéro}} / F'_C$$

$$\delta'_Y = M'_{\text{X-faéro}} / F'_C$$

avec : $M'_{\text{X-faéro}}$ pour la composante du moment de la force aérodynamique s'exerçant sur la section inférieure de l'échasse de l'aube selon la direction longitudinale ; et $M'_{\text{Y-faéro}}$ pour la composante du moment de la force aérodynamique s'exerçant sur la section inférieure de l'échasse de l'aube selon la direction tangentielle

**2.** Procédé selon la revendication 1, dans lequel les valeurs de déplacements à appliquer aux centres de gravité des tranches de pale et à l'échasse de l'aube sont lissées sur toute la hauteur de l'aube (E160).

**3.** Procédé selon l'une des revendications 1 et 2, dans lequel la force centrifuge ($F_C$) à laquelle est soumise une tranche de pale est donnée par la formule suivante :

$$F_C = M_T \times R_{CDG} \times \omega^2$$

avec : $M_T$ pour la masse de la tranche de pale, $R_{CDG}$ pour la distance entre l'axe de rotation du disque et le centre de gravité de la tranche de pale ; et $\omega$ pour la vitesse de rotation du disque au régime prédéterminé.

**4.** Procédé selon l'une quelconque des revendications 1 à 3, dans lequel l'aube comprend en outre un talon au voisinage de l'extrémité libre de la pale, l'étape de compensation de l'échasse s'appliquant à une portion de l'aube constituée de la pale, de la plateforme, de l'échasse et du talon de l'aube

**5.** Procédé selon l'une quelconque des revendications 1 à 4, dans lequel, dans l'étape de compensation de la pale de l'aube, la pale est divisée en dix tranches s'étendant chacune sur 10% de la hauteur totale de la pale.

**Patentansprüche**

**1.** Verfahren zur Optimierung des Profils einer Schaufel aus Verbundwerkstoff für ein Laufrad einer Turbomaschine, wobei die Schaufel ein Blatt, welches aus einer Vielzahl von in einer zu dem Rad radialen Richtung gestapelten Schaufelabschnitten besteht, einen Fuß, welcher dazu bestimmt ist, an einer Scheibe des Rades angebracht zu werden, und welcher durch eine Stelze fortgesetzt ist, sowie eine zwischen der Stelze und dem Blatt gelegene Plattform umfasst, wobei der Fuß durch einen Hals an die Stelze anschließt, wobei das Verfahren **dadurch gekennzeichnet ist, dass** es die folgenden aufeinanderfolgenden Schritte umfasst:

einen Schritt zum Ausgleichen des Blattes der Schaufel, der darin besteht, das Blatt in Teile, die jeweils zwischen einem unteren Abschnitt und einem oberen Abschnitt begrenzt sind, zu unterteilen (E110) und für jeden Blattteil und eine vorbestimmte Drehzahl der Scheibe des Rades die Fliehkraft ($F_C$) zu berechnen, welcher der Teil ausgesetzt ist (E120), das Moment der aerodynamischen Kraft, die auf den unteren Abschnitt des Teils ausgeübt wird, zu berechnen (E130) und Bewegungswerte zu berechnen (E140), die auf einen Schwerpunkt des Teils in Tangential- und Längsrichtung anzuwenden sind, um das Moment der aerodynamischen Kraft, welche auf den unteren Abschnitt des Teils ausgeübt wird, aufzuheben, wobei die auf den Schwerpunkt eines Blattteils anzuwendenden Bewegungswerte ($\delta_X$, $\delta_Y$) durch die folgenden Formeln gegeben sind:

$$\delta_X = M_{Y\text{-}faéro} / F_C$$

$$\delta_Y = M_{X\text{-}faéro} / F_C$$

mit: $M_{X\text{-}faéro}$ für die Komponente des Moments der aerodynamischen Kraft, welche auf den unteren Abschnitt des Teils in der Längsrichtung ausgeübt wird, und $M_{Y\text{-}faéro}$ für die Komponente des Moments der aerodynamischen Kraft, welche auf den unteren Abschnitt des Teils in der Tangentialrichtung ausgeübt wird, und einen Schritt zum Ausgleichen der Stelze der Schaufel, der darin besteht, die Fliehkraft ($F'_C$) zu berechnen, welcher ein oberhalb des Halses gelegener und von dem Blatt (E200), der Plattform und der Stelze gebildeter Abschnitt der Schaufel ausgesetzt ist, das Moment der aerodynamischen Kraft, welche auf den unteren Abschnitt der Stelze der Schaufel ausgeübt wird, zu berechnen (E210), und Bewegungswerte zu berechnen (E220), die auf einen Schwerpunkt der Stelze der Schaufel in Tangential- und Längsrichtung anzuwenden sind, um das Moment der aerodynamischen Kraft, die auf den unteren Abschnitt der Stelze der Schaufel ausgeübt wird, aufzuheben, wobei die auf den Schwerpunkt eine Teils der Stelze anzuwendenden Bewegungswerte ($\delta'_X$, $\delta'_Y$) durch die folgenden Formeln gegeben sind:

$$\delta'_X = M'_{Y\text{-}faéro} / F'_C$$

$$\delta'_Y = M'_{X\text{-}faéro} / F'_C$$

mit: $M'_{X\text{-}faéro}$ für die Komponente des Moments der aerodynamischen Kraft, welche auf den unteren Abschnitt der Stelze der Schaufel in der Längsrichtung ausgeübt wird, und $M'_{Y\text{-}faéro}$ für die Komponente des Moments der aerodynamischen Kraft, welche auf den unteren Abschnitt der Stelze der Schaufel in der Tangentialrichtung ausgeübt wird.

2. Verfahren nach Anspruch 1, bei dem die auf die Schwerpunkte der Blattteile und auf die Stelze der Schaufel anzuwendenden Bewegungswerte über die gesamte Höhe der Schaufel geglättet sind (E160).

3. Verfahren nach einem der Ansprüche 1 und 2, bei dem die Fliehkraft ($F_C$), der ein Blattteil ausgesetzt ist, durch die folgende Formel gegeben ist:

$$F_C = M_T \times R_{CDG} \times \omega^2$$

mit: $M_T$ für die Masse des Blattteils, $R_{CDG}$ für den Abstand zwischen der Rotationsachse der Scheibe und dem Schwerpunkt des Blattteils, und $\omega$ für die Rotationsgeschwindigkeit der Scheibe bei der vorbestimmten Drehzahl.

4. Verfahren nach einem der Ansprüche 1 bis 3, bei dem die Schaufel ferner ein Deckband in der Nähe des freien Endes des Blattes umfasst, wobei der Schritt des Ausgleichens der Stelze auf einen Abschnitt der Schaufel, bestehend aus dem Blatt, der Plattform, der Stelze und dem Deckband der Schaufel, angewandt wird.

5. Verfahren nach einem der Ansprüche 1 bis 4, bei dem das Blatt bei dem Schritt des Ausgleichens des Blattes der Schaufel in zehn Teile, die sich jeweils über 10 % der Gesamthöhe des Blattes erstrecken, unterteilt wird.

**Claims**

1. A method of optimizing the profile of a composite material blade for a rotor wheel of a turbine engine, the blade comprising an airfoil constituted by a plurality of blade sections stacked in a radial direction of the wheel, a root for mounting on a disk of the wheel and extended by a tang, and an inner platform situated between the tang and the airfoil, the root being connected to the tang by a neck, the method being **characterized in that** it comprises the following steps:

   a step of compensating the blade airfoil, which step consists in subdividing (E110) the airfoil into slices, each defined between a bottom section and a top section, and for each airfoil slice and for a predetermined speed of rotation of the wheel disk, calculating (E120) the centrifugal force ($F_C$) to which the slice is subjected, calculating (E130) the moment of the aerodynamic force acting on the bottom section of the slice, and calculating (E140) shift values to be applied to the center of gravity of the slice in tangential and longitudinal directions in order to cancel the moment of the aerodynamic force acting on the bottom section of said slice, the shift values ($\delta_X$, $\delta_Y$) for application to the center of gravity of an airfoil slice being given by the following formulas:

$$\delta_X = M_{Y-faero} / F_C$$

$$\delta_Y = M_{X-faero} / F_C$$

   with: $M_{X\text{-}faero}$ being the component of the moment of the aerodynamic force acting on the bottom section of the slice in the longitudinal direction; and $M_{Y\text{-}faero}$ being the component of the moment of the aerodynamic force acting on the bottom section of the slice in the tangential direction,
   and
   a step of compensating the blade tang, consisting in calculating (E200) the centrifugal force ($F'_C$) to which a portion of the blade situated above the neck is subjected, which portion is constituted by the airfoil, by the inner platform, and by the tang, calculating (E210) the moment of the aerodynamic force acting on a bottom section of the tang of the blade, and calculating (E220) shift values to be applied to a center of gravity of the blade tang along the tangential and longitudinal direction in order to cancel the moment of the aerodynamic force acting on the bottom section of the blade tang, the shift values ($\delta'_X$, $\delta'_Y$) for application to the center of gravity of an airfoil slice being given by the following formulas:

$$\delta'_X = M'_{Y-faero} / F'_C$$

$$\delta'_Y = M'_{X-faero} / F'_C$$

   with: $M'_{X\text{-}faero}$ being the component of the moment of the aerodynamic force acting on the bottom section of the blade tang in the longitudinal direction; and $M'_{Y\text{-}faero}$ being the component of the moment of the aerodynamic force acting on the bottom section of the blade tang in the tangential direction.

2. A method according to claim 1, wherein the shift values to be applied to the centers of gravity of the airfoil slices and to the blade tang are smoothed over the full height of the blade (E160).

3. A method according to claim 1 or claim 2, wherein the centrifugal force ($F_C$) to which an airfoil slice is subjected is given by the following formula:

$$F_C = M_T \times R_{COG} \times \omega^2$$

   with $M_T$ being the mass of the airfoil slice; $R_{COG}$ being the distance between the axis of rotation of the disk and the center of gravity of the airfoil slice; and $\omega$ being the speed of rotation of the disk at the predetermined speed.

4. A method according to any one of claims 1 to 3, wherein the blade also includes an outer platform in the vicinity of the free end of the airfoil, and the step of compensating the tang applies to a portion of the blade constituted by the airfoil, the inner platform, the tang, and the outer platform of the blade.

5. A method according to any one of claims 1 to 4, wherein, in the step of compensating the blade airfoil, the airfoil is subdivided into ten slices, each occupying 10% of the total height of the airfoil.

FIG.1

ANALYSE DU PROFIL DE L'AUBE — E100

↓

DIVISION DE LA PALE EN PLUSIEURS TRANCHES T — E110

↓

CALCUL DE $F_c$ POUR LA TRANCHE T — E120

↓

CALCUL DE $M_{faéro}$ POUR LA TRANCHE T — E130

↓

CALCUL DES VALEURS DE DEPLACEMENT $\delta_x, \delta_y$ — E140

↓

CALCUL DES COORDONNEES MODIFIEES DU CENTRE DE GRAVITE DE LA TRANCHE T — E150

REPETITION POUR L'ENSEMBLE DES TRANCHES DE LA PALE

↓

LISSAGE SUR TOUTE LA HAUTEUR DE LA PALE — E160

↓

E200 — CALCUL DE $F'_c$ POUR LA PORTION P DE L'AUBE

↓

E210 — CALCUL DE $M'_{faéro}$ POUR LA PORTION P DE L'AUBE

↓

E220 — CALCUL DES VALEURS DE DEPLACEMENT $\delta'_x, \delta'_y$

↓

E230 — CALCUL DES COORDONNEES MODIFIEES DU CENTRE DE GRAVITE DE LA PORTION P DE L'AUBE

## FIG.2

**EP 2 638 249 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- FR 2939129

- US 4012172 A